Europäisches Patentamt

European Patent Office

Office européen des brevets

(11) Publication number: **0 164 461**

**A1**

# EUROPEAN PATENT APPLICATION

(21) Application number: **84303829.0**

(22) Date of filing: **06.06.84**

(51) Int. Cl.⁴: **B 41 M 5/24**

(43) Date of publication of application:
**18.12.85 Bulletin 85/51**

(84) Designated Contracting States:
**AT BE CH IT LI NL SE**

(71) Applicant: **RONEO ALCATEL LIMITED**
**P.O. Box 3 South Street**
**Romford Essex RM1 2AR(GB)**

(72) Inventor: **Figov, Murray**
**Room 209 Merkaz Klitta**
**Hasharon Street Raananah IL-43000(IL)**

(72) Inventor: **Stephenson, Raymond Owen**
**33 Chestnut Avenue**
**Billericay Essex CM12 9JG(GB)**

(72) Inventor: **Jude, Rodney Francis**
**11 Keats Walk Hutton**
**Brentwood Essex CM13 2RY(GB)**

(74) Representative: **Cole, Paul Gilbert et al,**
**Hughes Clark Andrews & Byrne 63 Lincoln's Inn Fields**
**London WC2A 3JU(GB)**

(54) IMprovements in or relating to electro-sensitive materials.

(57) A normally opaque recording sheet is provided that can be converted by spark erosion into an image of an original that has low background in areas corresponding to black areas of the original. It comprises an optically transmissive insulating carrier sheet, an opaque layer of aluminium, chromium or nickel deposited on the carrier sheet which layer is from 0.025 to 1 micron thick and has a surface resistance of from 2 to 0.5 ohms per square, and an insoluble opaque spark-erodible protective layer comprising electrically conductive particles dispersed in a resin and coated onto the aluminium layer in an amount of from 3 to 18 g.s.m. Both the protective layer and the over-layer can be eroded away by passing electrical current between the recording sheet and a moving electrical stylus. The resulting positive or negative imaged recording sheet can be employed in transmission either to produce film intermediate positives or negatives, or by contact with pre-senstised offset litho plates to produce long run lithographic plates. The opaque over layer and the opaque image area both remain in non-image areas and are both present in imaged areas so that a low background is achieved.

# IMPROVEMENTS IN OR RELATING TO ELECTRO-SENSITIVE MATERIALS

The present invention relates to an electro-sensitive recording sheet on which written or pictorial records may be inscribed by means of a recording stylus and to the use of such a recording sheet in the preparation of offset lithographic plates.

The application of spark erosion to the production of offset lithographic plates is well known. In U.S. Patent No. 4086853 (Murray Figov et al, assigned to Vickers Limited) there was described an electrically inscribable lithographic printing blank ("a Lithoscan plate") in which a thin layer of aluminium chromium or nickel was vapour-deposited onto an electrically nonconductive under-layer that was hydrophobic and receptive to lithographic oleo ink. The electrically conductive hydrophilic metal over-layer would be rendered repellent to lithographic oleo ink by wetting. The over-layer was coated with a solid and electrically partially conductive over-layer formed from a mixture of electrically partially conductive solid material and a film forming resin material. The over-layer was to be totally removable by treatment with a solvent which left the under-layer and over-layer intact, the protective over-layer serving to inhibit mechanical abrasion of the under-layer during inscription of the blank with an electrical stylus. During imaging of the lithoscan plate an eletrical current was passed between the blank and a stylus while producing relative movement therebetween so as to remove locally both the protective layer and the over-layer. The inscribed blank was treated with solvent to remove the remainder of the protective layer whilst leaving the over-layer and the under-layer intact.

Lithoscan plates can be made to produce good line reproduction as well as excellent tone reproduction. By using colour filters it is possible to cut four colour separation plates to produce process colour work. But such plates have the disadvantage of lasting only for relatively short runs and they cannot ordinarily produce more than 2000 copies. This is because the hydrophilic part of the plate in the practical commerically sold version is a thin vacuum deposited aluminium layer. It is impossible to increase the run life of lithoscan plates by increasing the thickness of the aluminium layer because doing so adversely affects the electrical properties of the plate system, which reduces spark erosion and results in weak offset litho copies.

U.S. Patent No. 3122448 (Hills et al, assigned to Nashua), was concerned with the production of an inexpensive recording sheet material that could provide a record suitable for direct positive reproduction by a process such as the diazo process that required transparent contrast. A transluscent or semi-transparent and highly conducting base sheet was combined with a coating of a thermosensitive composition in which particles of electrically conductive material had been dispersed to make the coating behave as a semi-conductor. The coating could be fused by a trace electrode or stylus into transparency along the path followed by the electrode. In the practical embodiment a film of polyester or other transparent material was coated with a thin optically transmissive deposit of aluminium coated with an electrosensitised blushed lacquer or other coating material that preferably fused to transparency (as opposed to disintegrating) on passage of an electrical current. But the Hills et al plate is opaque only in its top layer, and if employed in an electroresponsive spark erosion scanner of the kind used for lithoscan plates there would be an unacceptably high background because of mechanical abrasion both before and during inscription, and Hills et al give no indication that their recording sheet might be used in the production of a lithographic plate.

The invention is based on the discovery that a transparent carrier sheet or under-layer can be coated with an opaque aluminium over layer and then with a second opaque protective layer having electrically conductive particles dispersed in a resin to produce a recording sheet, that both the protective layer and the over-layer can be eroded away by passing electric current between the recording sheet and a moving electrical stylus, and that the resulting positive or negative imaged recording sheet can be employed in transmission either to produce film intermediate positives or negatives or by contacting with pre-sensitized offset litho plates to produce long run plates capable of producing tens or even thousands of copies. By a combination of opaque over-layer and opaque protective layer both of which remain in non-image areas (while both are removed in image areas), a low background is achieved that gives good lithographic plates.

The invention provides a normally opaque recording sheet that can be converted by spark erosion into an image of an original that has low background in areas corresponding to black areas of the original, comprising in combination:

an optically transmissive insulating carrier sheet;

an opaque layer of aluminium, chromium or nickel deposited on the carrier sheet which layer is from 0.025 to 1 micron thick and has a surface resistance of from 2 to 0.5 ohms per square; and

insoluble opaque spark-erodible protective layer comprising electrically conductive particles dispersed in a resin and coated onto the aluminium layer in an amount of from 3 to 18 g.s.m.

The under-layer may consist of a sheet of two mil Mylar polyester film (1 mil = 0.001inch = 25.4 microns), although other transparent materials such as a cellulose acetate film may be used. The under-layer is coated with a layer of metal, preferably vacuum deposited aluminium. It is a requirement that the over-layer should be capable of acting as an electrode for the stylus current during inscription of the recording sheet whilst at the same time being capable of being removed by the stylus. If the resistivity is greater than 2 ohms per square the optical transmissivity of the over-layer will start to become significant. If the resistivity is less than 0.3 ohms per square the over-layer cannot be eroded successfully. In Hills et al the over-layer is transparent and not opaque and any erosion thereof while inscription is taking place is incidental and contributes to image formation as it does in the present invention.

In addition to its opacity, the over-layer must consist of a resin or a mixture of resins plus a pigment or a mixture of pigments and must have a coating weight of from 3 to 18 grams per square metre. It should have good handling properties and be sufficiently hard and abrasion proof without interfering with its electrical properties. Non cross-linked water soluble resins are unsuitable as the resin or as a major constituent of the resin mixture because they are attacked by sweat from the hands and cross-linked non-water soluble resins are also unsuitable because they are too resistant to spark erosion under the specified conditions. Examples of preferred resins which are non-cross linked but water insoluble are polyvinyl acetates, acrylic resins, vinyl/acrylate copolymers and styrenated resins. The protective layer should be sufficiently pigmented that it contributes significantly to the total opacity of the two layers (the protective layer and the over-layer) to UV and visible light. It is preferred that the protective layer should be entirely opaque to light so that any slight coating faults in the metal over-layer are entirely obscured. The conductive pigment particles present are preferably of zinc oxide, zinc sulphide or carbon black and they are preferably present in an amount such as will give a DC breakdown voltage between an electrical stylus and the over-layer of from 10 to 400 volts. Where zinc oxide or zinc sulphide are incorporated into the protective layer, they are preferably present in an amount of from 14% to 50% by total dry weight and in order to achieve good opacity up to 40% by total dry weight of titanium dioxide may be added. Where carbon black is employed it should have a high electrical resistivity and suitable carbon blacks incude Mogul L, Special Black 4 and Raven 1255. The carbon black may be present in an amount of from 5 to 20% by total dry weight and it may be desirable to incorporate 25 to 40% by total dry weight of a filler such as a clay. The protective layer may be applied as by roller coating a suspension of the pigment particles in a solution of the resin in a volatile organic solvent such as toluene and allowing the solvent to evaporate.

The recording sheet is inscribed in an electroresponsive spark erosion scanner in which a current is passed between the blank and the stylus while relative movement is produced therebetween. Thereby the protective layer and the over-layer are inscribed and the under-layer is locally exposed. The underlayer must merely be exposed. The compositions of the protective layer and the overlayer must be such that when the underlayer is exposed it is unetched during spark erosion. If it is etched, it is light opaque rather than light transmitting which is undesirable. The protective layer serves to prevent abrasion of the over-layer while this is taking place. In a typical scanner a cylindrical drum is mounted concentrically on a rotatable shaft. An original document to be reproduced and a flexible electro-responsive recording sheet are stretched side-by-side around the cylindrical surface of the drum. On an axially displaceable shaft parallel to the rotatable shaft is mounted a stylus-carrying arm that supports an electronically operable stylus adjacent to the blank. An optical scanning device is also mounted on the shaft and it has a photohead supported adjacent to the document. As the shaft is rotated, the blank and the document rotate with the drum. Simultaneously, the shaft is made to traverse the drum axially so that the photohead scans the surface of the document and the stylus synchronously scans the surface of the recording sheet.

For colour printing the original can be inscribed successively using red, blue and green filters. Because the pattern cut by the stylus is random, there is no Moire effect when the three resultant images are combined even where the original is screened. Furthermore a coloured original can be scanned to produce an image that can be used for black and white printing.

The imaged recording sheet may be used directly to produce a lithographic plate by direct contact exposure after which the exposed plate is treated to remove non-image areas. Alternatively, a photographic proofing material may be exposed through the inscribed recording sheet and developed to produce an internegative which is then used to expose a presensitised offset lithographic plate.

The invention is believed to be particularly suited to the needs of small jobbing printers who wish to offer a colour printing facility without involving themselves in time consuming procedures and elaborate equipment. It· provides a method for reproduction from a screened printed copy without resorting to photographic origination. Also it forms the basis of a process not involving a darkroom.

The invention is illustrated in the following Examples.

Example I

A formulation of the following composition was made up and ground in a ball mill for 4 hours

18 grams Synolac 608S (vinyl acrylic copolymer resin supplied by Cray Valley Products)

13 grams Ethyl Cellulose K5000 (supplied by Hercules)

86 grams Zinc Oxide

17 grams Titanium Dioxide

173 grams Industrial Methylated Spirit

693 grams Toluene

The mixture was then bar coated onto 50 micron aluminized polyester and the solvents evaporated leaving a dry top layer of 8 grams per square metre.

Example II

A formulation of the following composition was treated as in Example I but giving a black opaque top layer at a solids weight of 12 grams per square metre.

40 grams Mogul L Carbon Black (supplied by Cabot Carbon) 160 grams Satintone Special Clay (supplied by Laurence Industries) 400 grams E312 (50% solution (Isopropyl alcohol/toluene) of a modified acrylic resin supplied by De Soto Inc.)

400 grams Toluene.

CLAIMS

1. A normally opaque recording sheet that can be converted by spark erosion into an image of an original that has low background in areas corresponding to black areas of the original, comprising in combination:

   an optically transmissive insulating carrier sheet;

   an opaque layer of aluminium, chromium or nickel deposited on the carrier sheet which layer is from 0.025 to 1 micron thick and has a surface resistance of from 2 to 0.5 ohms per square; and

   and insoluble opaque spark-erodile protective layer comprising electrically conductive particles dispersed in a resin and coated onto the aluminium layer in an amount of from 3 to 18 g.s.m.

2. A recording sheet according to claim 1, wherein the carrier sheet is of polyester film.

3. A recording sheet according to claim 1, wherein the electrically conductive particles of the protective layer are of zinc oxide, sulphide, carbon black or mixtures thereof.

4. A recording sheet according to claim 3, wherein the protective layer comprises additionally particles of titanium dioxide or clay.

5. A recording sheet according to claim 4, wherein the protective layer comprises 14 - 50% by weight of zinc oxide up to 40% by weight of titanium dioxide and a vinyl acrylic resin or modified acrylic resin.

6. A recording sheet according to claim 4, wherein the protective layer comprises 5 to 20% by weight of carbon black, 25-40% of a clay and a vinyl acrylic resin or modified acrylic resin.

7. A method of preparing an offset lithographic printing plate that comprises imaging a recording sheet as claimed in claim 1 by means of an electroresponsive spark erosion scanner in which the recording is inscribed by passing electric current between the recording sheet and an electrical stylus to cause       local removal from the opaque layer and the over-layer, exposing through the imaged recording sheet a presensitised offset lithographic plate and treating the exposed plate to remove non-image areas.

8. A method of preparing an offset lithographic plate which comprises imaging a recording sheet as claimed in claim 1 by means of an electroresponsive spark erosion scanner as defined above, exposing a photographic proofing material through the resulting inscribed recording sheet and developing it to produce an intermediate negative, exposing a presensitised offset lithographic plate through the intermediate negative and treating the exposed plate to remove non-image areas.

9. A method according to claim 8, in which the recording sheet is exposed through a red, blue or green filter.

10. A method according to claim 8, in which the imaged face of the recording sheet is in contact with the effective face of the lithographic plate.

# EUROPEAN SEARCH REPORT

**European Patent Office**

**0164461**
Application number

EP 84 30 3829

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X,Y | US-A-3 411 948 (C.S. REIS)(19-11-1968) * Whole document * | 1-9 | B 41 M 5/24 |
| X | US-A-3 514 325 (D.R. DAVIS)(26-05-1970) * Whole document * | 1-9 | |
| X | GB-A-1 244 177 (THE MARCONI INTERNATIONAL)(25-08-1971) * Whole document * | 1-9 | |
| X | DE-A-2 434 105 (R. BOSCH)(29-01-1976) * Whole document * | 1-9 | |
| Y | US-A-4 086 853 (M. FIGOV et al.)(02-05-1978) * Whole document * | 1-9 | TECHNICAL FIELDS SEARCHED (Int. Cl.4) |
| Y | FR-A-2 333 406 (SIEMENS)(24-06-1974) * Claims 1,9 * | 1,7,10 | B 41 M 5/24 |
| Y | DE-A-2 427 788 (GRACE)(02-01-1975) * Claims * | 1,7-10 | |
| | --- -/- | | |

The present search report has been drawn up for all claims

| Place of search | Date of completion of the search | Examiner |
|---|---|---|
| THE HAGUE | 06-02-1985 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

European Patent
Office

EUROPEAN SEARCH REPORT

0164461
Application number

EP 84 30 3829

| | DOCUMENTS CONSIDERED TO BE RELEVANT | | Page 2 |
|---|---|---|---|
| Category | Citation of document with indication, where appropriate, of relevant passages | Relevant to claim | CLASSIFICATION OF THE APPLICATION (Int Cl 4) |
| A | EP-A-0 030 642 (IBM)(24-06-1981) * Claims * | 1 | |
| A | GB-A-1 545 726 (SEKISUI)(16-05-1979) * Claims * | 1 | |
| A | DERWENT JAPANESE PATENTS REPORT, vol. 75, no. 25, 18th July 1975, page 2, section G, "Electrosensitive recording", London, GB; & JP - B - 75 016 653 | 1 | |
| | | | TECHNICAL FIELDS SEARCHED (Int. Cl 4) |

The present search report has been drawn up for all claims

| Place of search THE HAGUE | Date of completion of the search 06-02-1985 | Examiner RASSCHAERT A. |
|---|---|---|